# FASCICULE DE BREVET EUROPEEN

(11) **EP 1 846 874 B1**
(45) Date de publication et mention de la délivrance du brevet: **05.11.2008**
(21) Numéro de dépôt: 06707949.1
(22) Date de dépôt: 01.02.2006
(51) Int. Cl.: G06K 19/077

(54) **PROCEDE DE PLACEMENT D'UN ENSEMBLE ELECTRONIQUE SUR UN SUBSTRAT ET DISPOSITIF DE PLACEMENT D'UN TEL ENSEMBLE**
VERFAHREN ZUR ANBRINGUNG EINER ELEKTRONISCHEN BAUGRUPPE AN EINEM SUBSTRAT UND EINRICHTUNG ZUR ANBRINGUNG DER BAUGRUPPE
METHOD FOR APPLYING AN ELECTRONIC ASSEMBLY TO A SUBSTRATE AND A DEVICE FOR APPLYING SAID ASSEMBLY

(30) Priorité: 01.02.2005 EP 05100694; 30.09.2005 EP 05109094
(43) Date de publication de la demande: 24.10.2007
(73) Titulaire: Nagraid SA, 2322 Crêt-du-Locle (CH)
(72) Inventeur: DROZ, François, CH-2035 Corcelles (CH)
(74) Mandataire: Wenger, Joel-Théophile
(86) Numéro de dépôt international: PCT/EP2006/050585
(87) Numéro de publication internationale: WO 2006/082199

(56) Documents cités:
- EP-A- 0 694 871
- FR-A- 2 780 534
- US-A1- 2004 194 876

## Description

### Domaine technique

La présente invention concerne le domaine de l'assemblage de transpondeurs, de carte à puce, de circuits intégrés ou autre support de données numériques et plus particulièrement le placement, le montage et la connexion d'ensembles électroniques sur un support isolant plus couramment appelé substrat.

### Art antérieur

On entend par ensemble électronique un composant sous la forme d'une puce semi-conductrice munie sur l'une de ses faces de plages de contacts électriques sur lesquels sont disposées des segments de pistes conductrices prolongeant lesdits contacts. Ces segments de pistes constituent des connexions reliant la puce à des éléments externes localisés sur le substrat. Par exemple, dans un transpondeur les segments de pistes de l'ensemble servent à le connecter aux extrémités d'une antenne disposée sur le pourtour du substrat.

Il existe plusieurs procédés de placement et de connexion d'une puce ou d'un ensemble électronique sur un substrat comportant des pistes conductrices à savoir.

Le document EP0694871 décrit un procédé de placement d'une puce effectué à l'aide d'un outil de pressage à chaud. La puce est saisie par l'outil, la face comportant les contacts étant dirigée vers le haut, puis pressée à chaud dans la matière du substrat. La face comportant les contacts affleure la surface du substrat. Les connexions sont réalisées par sérigraphie ou par traçage de pistes au moyen d'une encre conductrice reliant les contacts de la puce à une antenne par exemple. Selon une variante, un segment de piste est posé sur le substrat et la puce est pressée à chaud avec la face portant les contacts dirigée vers le substrat de manière à réaliser une connexion par la pression d'un contact de ladite puce sur le segment de piste.

Dans le document WO98/26372, la puce comporte des contacts en relief et elle est posée avec la face portant les contacts dirigée vers le substrat. Les contacts de la puce sont appliqués contre des bornes conductrices d'une antenne imprimée sur le substrat. Une feuille intermédiaire en matière plastique est superposée sur le substrat ainsi équipé en recouvrant la puce. Une seconde feuille recouvre le substrat avant le laminage à chaud de cet assemblage de feuilles. Ce procédé appelé technique de la "puce retournée" ou "flip chip" permet de réaliser en une seule opération la pose et la connexion de la puce et de garantir une épaisseur minimale à l'assemblage.

Le document WO98/44452 décrit un procédé de fabrication d'une carte à puce comprenant au moins un microcircuit dans le substrat de la carte. Le microcircuit est posé de sorte que les plots de sortie soient dirigés vers le haut. La connexion des plots avec des contacts d'une antenne situés sur la surface du substrat est effectuée par dépôt d'encre conductrice au moyen d'une seringue. Le microcircuit est posé au fond d'une cavité de profondeur plus grande que son épaisseur de manière à laisser un espace permettant de recouvrir ledit microcircuit de résine après réalisation des connexions. Ces dernières épousent le profil du microcircuit et celui de la cavité avant d'aboutir aux contacts ou aux pistes imprimées sur la surface du substrat.

Dans le procédé du document EP1410322, un module complet comprenant une puce équipée de plages de contact est placé à partir d'une bande support sur un substrat, comportant des pistes conductrices imprimées, également disposé en bande. Un module parmi ceux fixés sur la bande est placé en regard d'une portion de bande munie d'un ensemble de pistes conductrices formant, par exemple, une antenne. Puis, il est détaché de la bande pour être collé sur le substrat à proximité des terminaisons de l'antenne. La connexion des plages de contacts du module à l'antenne est effectuée par pression et sertissage avec un dispositif approprié lors du collage du module.

Le document FR2780534 décrit un procédé de fabrication d'un objet comportant un corps comprenant une pastille semi-conductrice munie de plages de contact sur une de ses faces et des métallisations formant une antenne. Le procédé consiste à insérer la pastille par pressage à chaud dans une plaquette en matériau thermoplastique. La face de la pastille munie des plages de contact est placée de manière qu'elle affleure une des faces de la plaquette. Les métallisations formant l'antenne ainsi que les raccordements des plages de contact de la pastille sont réalisés sur la même face de la plaquette par sérigraphie d'une encre conductrice.

Ce procédé devient inapplicable lorsque les dimensions de la pastille semi-conductrice sont très petites, de l'ordre de quelques dixièmes de millimètres. En effet, la sérigraphie ou le dépôt de matière conductrice par un autre procédé (traçage, projection) ne permet pas d'atteindre la précision nécessaire permettant d'éviter les court-circuits ou les ruptures de contact au niveau des plages de connexion de la pastille.

L'inconvénient principal des procédés de placement et de connexion ci-dessus est leur manque de précision surtout lorsque les dimensions de la puce formant l'ensemble électronique sont très réduites, par exemple 0.2 mm sur 0.2 mm. De plus, la distance très faible, de l'ordre de 0.05 mm, séparant les segments de piste attachés aux contacts de la puce, nécessite une grande précision de positionnement et de connexion.

Dans les trois premiers exemples, une puce ou un microcircuit seul est placé sur le substrat soit avec les contacts pressés sur des pistes imprimées sur une face du substrat (puce retournée), soit avec les contacts apparents connectés ultérieurement. Ces deux types de procédés deviennent peu fiables lorsque la taille de la puce et celle des contacts diminue.

Dans l'avant-dernier exemple, les modules sont fabriqués séparément et disposés sur une bande avant d'être posés sur le substrat. Ce procédé s'est aussi révélé relativement lent et coûteux.

### Description sommaire de l'invention

Le but de la présente invention est d'assurer une précision maximale tant au niveau de la fabrication d'un ensemble électronique à partir d'une puce de petites dimensions qu'à celui du placement d'un tel ensemble sur un substrat isolant. Un autre but est d'atteindre un coût de production de transpondeurs très bas avec une cadence de fabrication élevée.

Ces buts sont atteints par un procédé selon la revendication 1.

Le terme de substrat se rapporte ici à tout support isolant que ce soit une carte, une étiquette, un objet ou une portion de la structure de l'objet (boîtier d'appareil, badge, boîte, fourre d'emballage, document, etc.) susceptible d'être équipé d'un ensemble électronique selon le procédé ci-dessus.

Selon une réalisation préférée, le segment de piste consiste en une lamelle de forme quelconque étampée à partir d'une feuille de matériau conducteur à l'aide d'un outil d'étampage. Il est ensuite transféré sur le dispositif de pose qui le maintient par exemple au moyen d'un dispositif d'aspiration d'air. En général, le nombre de segments de piste étampés correspond au nombre de contacts de la puce. Ils sont maintenus par le dispositif de pose selon un arrangement dépendant de la disposition des contacts sur la puce. Leur forme et leurs dimensions individuelles sont aussi déterminées par la configuration des contacts de la puce ainsi que par celle des pistes conductrices du substrat.

Les segments de piste peuvent aussi constituer une antenne d'un transpondeur fonctionnant par exemple dans le domaine des fréquences UHF (Ultra High Frequency). Dans un cas de figure, l'extrémité du segment qui n'est pas connectée à la puce reste libre, c'est-à-dire sans connexion à d'autres pistes sur le substrat. Selon une autre configuration, le segment forme une boucle dont chaque extrémité est connectée à la puce. Un tel segment peut, bien entendu, être traité par le dispositif de pose de la même manière qu'un segment comportant une seule extrémité connectée à la puce.

Dans ce type de configuration, il n'est pas exclu que la puce comporte d'autres contacts à partir desquels des segments sont connectés à des pistes ou à des surfaces de contact disposées sur le substrat.

Le dispositif de pose sur lequel sont fixés les segments de piste saisit une puce, également par aspiration selon une réalisation, les extrémités des segments de piste étant appliquées contre les contacts de la puce. Cet ensemble est ensuite positionné et pressé à l'endroit prévu sur le substrat, les extrémités libres des segments de pistes se connectant aux terminaisons d'un circuit présent sur le substrat (par exemple, une antenne).

L'objet de la présente invention consiste également en un dispositif de pose

selon la revendication 34.

Les moyens de maintien du segment de piste sont constitués de préférence d'un dispositif d'aspiration d'air créant un vacuum sur l'une des faces du segment de piste. Un dispositif similaire peut être également prévu pour prendre une puce avec une extrémité du segment de piste appliquée contre un contact de la puce. L'ensemble ainsi monté est transporté vers un emplacement prédéterminé du substrat où il sera implanté. Le dispositif de pose comprend aussi des moyens de pressage de l'ensemble dans le substrat.

Un avantage de l'invention est d'éviter la réalisation d'un module intermédiaire par le fait que l'ensemble électronique est assemblé par le biais du dispositif de pose avant son placement sur le substrat.

L'invention se rapporte également à un objet portable comprenant sur tout ou partie de sa structure un substrat isolant dans la matière duquel est noyée au moins une puce électronique comportant une face munie d'au moins un contact, ladite face affleurant la surface du substrat, caractérisé en ce qu'au moins un segment de piste conductrice appliqué contre la surface du substrat est connecté au contact de la puce.

### Description des figures

L'invention sera mieux comprise grâce à la description détaillée qui va suivre et qui se réfère aux dessins annexés qui sont donnés à titre d'exemple nullement limitatif, dans lesquels:
- La figure 1 illustre l'étampage des segments de piste à partir d'une bande de matériau conducteur et une vue schématique de dessus en transparence du dispositif de pose maintenant une puce et les segments de piste.
- La figure 2 illustre une vue agrandie en coupe de l'ensemble électronique constitué de la puce et des segments de piste.
- La figure 3 montre une vue de dessus d'une portion de substrat où l'ensemble est placé et connecté à des pistes imprimées.
- La figure 4 montre une vue agrandie en coupe de la portion de substrat de la figure 3
- La figure 5 montre une vue schématique de dessous de la tête du dispositif de pose maintenant les segments de piste et la puce.
- La figure 6 illustre une variante où les segments de pistes sont étampés à partir d'une bande conductrice munie de zones isolantes.
- La figure 7 montre une vue de dessus d'une portion de substrat où les segments de pistes de l'ensemble munies de zones isolantes croisent et/ou se superposent à d'autres pistes du substrat.
- La figure 8 montre une vue de dessus d'une portion de substrat où les segments de pistes de l'ensemble de plus grande longueur et munies de zones isolantes sont collées sur le substrat en croisant des pistes.
- La figure 9 illustre une coupe agrandie d'une portion de substrat ou l'ensemble puce-segments est enfoncé dans le substrat.
- La figure 10 illustre une coupe agrandie d'une portion de substrat comportant un logement de dimensions supérieures à celles de la puce, l'ensemble puce-segments est maintenu dans le logement grâce à un adhésif remplissant les espaces libres.
- La figure 11 illustre une coupe agrandie d'une portion de substrat comportant un logement dont la profondeur est inférieure à la hauteur de la puce. La matière du substrat remplit les espaces libres lors de l'enfoncement de l'ensemble puce-segments dans le logement.
- La figure 12 illustre une coupe agrandie d'une portion de substrat formé de deux couches superposées, la couche supérieure comporte une fenêtre de dimensions sensiblement égales à celles de la puce, l'ensemble puce-segments étant enfoncé dans la fenêtre.
- La figure 13 illustre une coupe agrandie d'une portion de substrat formé de deux couches superposées, la couche supérieure comporte une fenêtre de dimensions supérieures à celles de la puce, l'ensemble puce-segments est maintenu dans le logement grâce à un adhésif remplissant les espaces libres.
- La figure 14 illustre une coupe agrandie d'une portion de substrat formé de deux couches superposées, la couche supérieure d'épaisseur inférieure à la hauteur de la puce comporte une fenêtre. La matière de la couche inférieure du substrat remplit les espaces libres lors de l'enfoncement de l'ensemble puce-segments dans la fenêtre.
- La figure 15 illustre une coupe agrandie d'une portion de substrat formé de deux couches superposées, la couche inférieure comporte une fenêtre. L'ensemble puce-segments est enfoncé dans la couche supérieure en regard de la fenêtre de la couche inférieure.
- La figure 16 illustre la coupe de la figure 15 avec l'ensemble puce-segments enfoncé dans la couche supérieure et la matière de cette dernière remplit la fenêtre de la couche inférieure.
- La figure 17 illustre une portion de substrat comprenant un ensemble puce segments avec des segments croisant des pistes conductrices en passant sur des segments isolants.

### Description détaillée de l'invention

Selon le procédé de l'invention, chaque ensemble électronique est monté avant son placement et sa connexion avec d'autres éléments présents sur le substrat. Des segments (3, 3') de pistes dont le nombre correspond en général au nombre de contacts (5, 5') de la puce (4) sont découpés dans une feuille (2) de matériau conducteur puis assemblés sur ces contacts (5, 5').

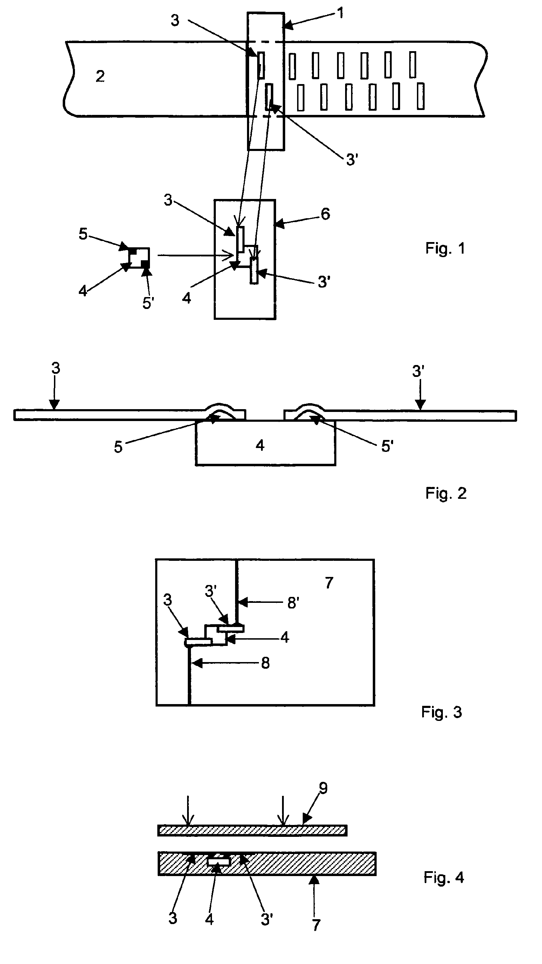

La figure 1 montre un exemple d'une paire de segments (3, 3') de piste rectangulaires disposés en quinconce étampée dans une feuille (2) ou une bande de cuivre provenant d'un rouleau par exemple. L'outil d'étampage (1) opère ici de bas en haut et repousse les segments (3, 3') découpés à sa surface supérieure de manière à pouvoir être transférés aisément sur le dispositif de pose (6). Ce dernier se place au-dessus de l'outil d'étampage (1) et aspire les segments (3, 3') en les maintenant dans la même position que lors de leur étampage. Une puce (4) électronique est ensuite saisie par le dispositif de pose (6) portant les segments (3, 3') de manière à ce que ses contacts (5, 5') touchent les extrémités les plus proches de chaque segment (3, 3') dans une zone centrale de la tête du dispositif de pose (6). La puce (4) est également maintenue sur le dispositif par aspiration de façon similaire aux segments de piste (3, 3').

L'ensemble ainsi formé porté par le dispositif de pose (6) est ensuite placé puis pressé, par exemple à chaud, dans un substrat (7) par le même dispositif. La surface de contact de l'ensemble étant dirigée vers le haut, affleure la surface du substrat (7) comme le montre la coupe de la figure 4 et les segments (3, 3') de piste sont posés à plat contre la surface du substrat (7).

Les extrémités libres des segments (3, 3') sont connectées par pression sur des terminaisons appropriées formées par des pistes (8, 8') conductrices disposées sur le substrat (7), voir la figure 3.

Dans une étape finale de l'assemblage, une feuille isolante (9) de protection est laminée, selon une technique connue, sur tout ou partie de la surface du substrat (7) assurant un maintien mécanique final de l'ensemble électronique constitué des segments (3, 3') de piste et de la puce (4), les connexions électriques ayant été réalisées au préalable.

Ce procédé de pose s'applique avantageusement, par exemple, lors de la fabrication de transpondeurs ou de cartes à puce sans contact où l'ensemble électronique est connecté, par exemple, aux extrémités d'une antenne.

La figure 2 montre une coupe d'un ensemble constitué d'une puce (4) comportant deux contacts (5, 5') munis chacun d'une protubérance. La connexion des segments (3, 3') de piste est effectuée par pression de sorte que les protubérances réalisent le contact électrique avec la matière conductrice du segment. Les protubérances peuvent également être composées d'un matériau conducteur fusible à une température relativement peu élevée (alliage à base d'étain, par exemple) de sorte que la connexion des segments de piste peut être réalisée à l'aide du dispositif de pose par apport de chaleur.

Lorsque le point de fusion du matériau des protubérances est plus élevé, comme par exemple dans le cas de l'or, des points de soudures supplémentaires, par exemple au laser, ultrasons ou aussi par thermo-compression, permettent d'assurer un contact électrique optimal. Ces opérations de soudures peuvent être effectuées soit avec le dispositif de pose lors ou après l'enfoncement de l'ensemble électronique dans le substrat (7) soit au cours d'une étape supplémentaire après la pose de l'ensemble électronique. Une autre possibilité consiste à utiliser un dispositif de soudage séparé du dispositif de pose pour souder, lors d'une étape préalable, le ou les segments (3, 3') conducteurs aux contacts (5, 5') de la puce (4) à température élevée. L'ensemble puce-segments est ensuite transféré sur le dispositif de pose qui le place sur le substrat (7) pour l'enfoncer à une température plus basse adaptée au ramollissement du substrat par exemple. Du fait de la température élevée du dispositif de soudage, cette opération de placement devient difficilement réalisable avec un seul dispositif effectuant à la fois le soudage et le placement sans dégrader le substrat.

Selon une variante, la connexion des segments (3, 3') de piste sur les contacts (5, 5') de la puce (4) peut être réalisée par un dépôt de colle conductrice sur ces contacts (5, 5') avant la saisie de la puce (4) par le dispositif de pose (6). Une autre possibilité est de déposer la colle conductrice sur l'extrémité des segments (3, 3') en regard des contacts (5, 5') de la puce (4). Cette opération est exécutée lors d'une étape précédant le transfert du segment (3, 3') sur le dispositif de pose (6) avant ou après son étampage. La colle peut également être déjà déposée sous forme inactive sur la feuille conductrice puis activée ultérieurement. Le collage des contacts (5, 5') de la puce (4) avec les segments (3, 3') de piste est ainsi effectué lors de la saisie de la puce (4) par le dispositif de pose (6) puis pendant ou après l'étape d'enfoncement de l'ensemble puce-segments dans le substrat (7).

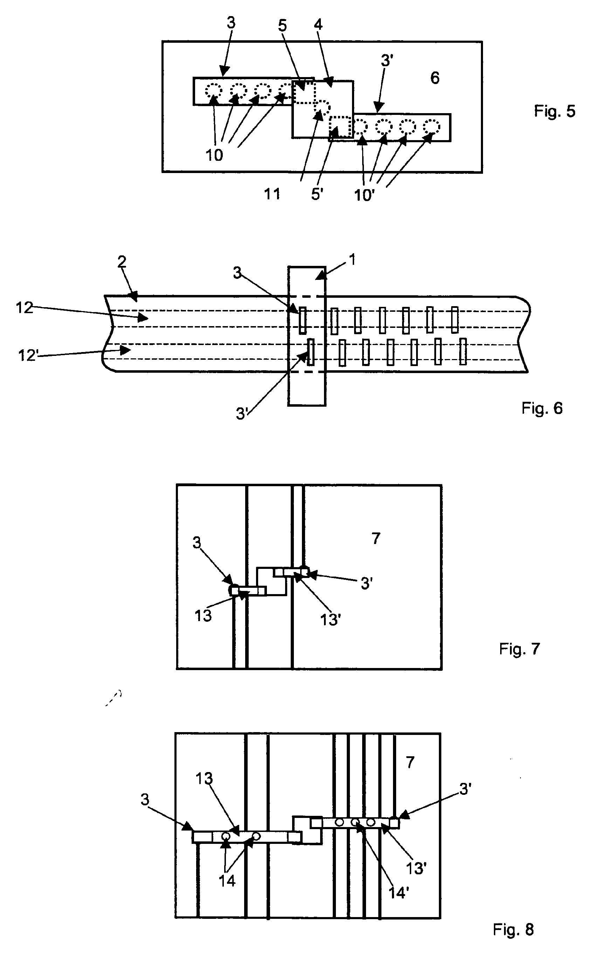

La figure 5 représente une vue schématique de dessous de la tête du dispositif de pose (6) selon l'invention équipée d'orifices (10, 10', 11) destinés à maintenir par aspiration d'air (vacuum) les différents éléments de l'ensemble électronique. Dans une première étape l'aspiration de l'air par les orifices (10, 10') permet de recueillir les segments (3, 3') de piste sur l'outil d'étampage (1) et de les maintenir en position. Dans une seconde étape, la puce (4) est saisie depuis un support adéquat également par aspiration de l'air au travers d'un orifice central (11). L'ensemble électronique ainsi constitué et retenu par le dispositif de pose est finalement transporté vers l'emplacement prévu sur le substrat (7) et pressé dans la matière. La tête du dispositif de pose (6) peut être constituée soit de plusieurs pièces assemblées les unes aux autres soit d'un seul bloc servant de support global à l'outil d'étampage, au système d'aspiration des segments et de la puce, aux moyens de soudure etc. selon un exemple de configuration.

La figure 6 montre une variante où la bande conductrice (2) dans laquelle sont étampés les segments (3, 3') de piste est pourvue de zones (12, 12') isolantes appliquées contre la face inférieure de la bande. Ces zones (12, 12') sont disposées de manière à former une partie médiane isolée (13, 13'), sur la face destinée à être appliquée contre le substrat, de chaque segment étampé à partir de cette bande (2).

Les extrémités des segments (3, 3') sont dégagées de la zone isolante afin d'assurer les connexions avec la puce (4) et les pistes ou les plages conductrices du substrat (7) prévues à cet effet. Cette isolation permet d'éviter des courts-circuits avec les pistes (8, 8') du substrat (7) que les segments croisent dans certaines configurations, comme illustré par la figure 7.

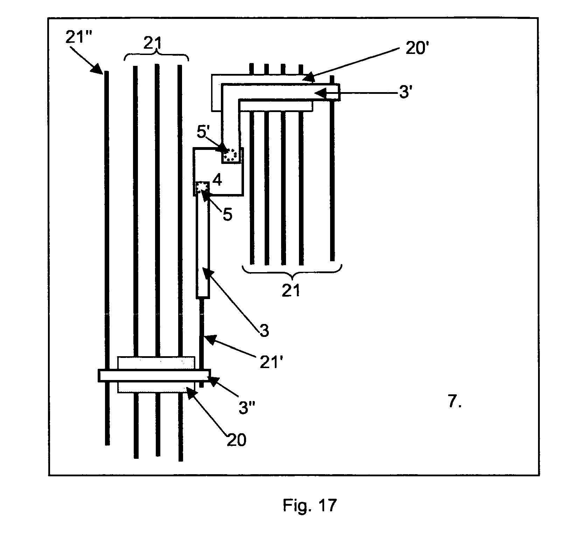

Selon une variante, les zones isolantes sur les segments peuvent être réalisées à partir de segments isolants obtenus d'une façon similaire aux segments conducteurs mais à partir d'un film isolant. Ces segments sont transférés sur le dispositif de pose sur lequel ils sont maintenus contre les segments de piste appropriés avant le placement et l'enfoncement de l'ensemble dans le substrat. Cette variante permet de réaliser des segments isolants de forme quelconque et notamment plus large que les segments conducteurs afin d'assurer une meilleure isolation d'un croisement de pistes par exemple (voir l'exemple de la figure 17)

Selon une autre variante illustrée par la figure 8, dans le cas où les segments (3, 3') auraient une longueur plus importante, le film isolant de la bande conductrice (2) peut comporter une couche de colle. Cette dernière, une fois activée, permet d'assurer le maintien du segment sur le substrat lorsqu'il croise plusieurs pistes par exemple. La couche de colle peut également être disposée sur le substrat (7) au lieu d'être appliquée sur le film isolant.

Lors de la pose de l'ensemble, les segments (3, 3') sont collés sur le substrat (7), par exemple, grâce à l'activation par un échauffement local de la couche de colle par le dispositif de pose (6) en des points (14, 14') situés en regard de la zone isolante. Ces points (14, 14') sont situés de préférence en dehors des pistes du substrat (7) permettant ainsi un meilleur collage.

Selon une variante, les opérations d'étampage des segments (3, 3') de pistes conductrices et de placement de l'ensemble peuvent être effectuées par le même dispositif. Dans ce cas, la tête du dispositif se complète par une étampe servant à la découpe des segments de pistes (3, 3'). Un retrait de l'étampe permet aux orifices (10, 10') d'aspiration de maintenir les segments (3, 3') dans la position adéquate avant la prise de la puce (4). L'étape de transfert des segments (3, 3') de pistes de l'outil d'étampage vers le dispositif de pose est alors supprimée.

Selon une autre variante, les moyens de saisie et de retenue de la puce comprennent des éléments adhésifs remplaçant le ou les orifices (11) dans la zone centrale du dispositif de pose (6). La puce (4) est alors collée temporairement entre ses contacts (5, 5') durant le transport de l'ensemble électronique vers son emplacement sur le substrat (7). Les éléments adhésifs ont une force de collage plus faible que celle de fixation de la puce (4) sur le substrat (7) de manière à permettre le retrait du dispositif de pose (6) après l'enfoncement de l'ensemble électronique. La colle peut subsister sur la puce (4) après la pose dans le but d'améliorer la planéité de la surface de l'ensemble électronique dans le cas où la puce (4) comporterait des contacts (5, 5') à protubérances.

Il est à noter que des éléments adhésifs conducteurs selon un axe vertical (axe z) peuvent également être ajoutés sur le dispositif de pose (6) en regard des contacts de la puce (4). Ceux-ci peuvent, soit remplacer les éléments adhésifs ou le ou les orifices d'aspiration (vacuum) de la zone centrale, soit les compléter.

Selon une variante, la tête du dispositif de pose (6) peut comporter des moyens de soudure des segments (3, 3') de pistes sur les contacts de la puce (4). Ces moyens de soudures sont constitués par exemple d'une source laser ou d'ultrasons ou d'un ou plusieurs corps de chauffe. Ils sont en général mis en oeuvre avant ou pendant le placement ou lors ou après l'enfoncement de l'ensemble électronique dans le substrat (7) afin d'exercer la pression nécessaire sur les éléments à souder.

Le procédé selon l'invention s'applique également à la fabrication d'étiquettes électroniques ou de transpondeurs comprenant un substrat non thermo-fusible c'est-à-dire qui ne fond ni ne se ramollit lors de l'élévation de la température. Ce dernier peut être constitué d'un matériau à base de cellulose comme le papier ou le carton. Dans un tel cas, il est préférable de créer une cavité dans laquelle sera placée la puce munie de ses segments de piste. La cavité peut être réalisée par fraisage ou enfoncement d'un poinçon après ramollissement préalable du substrat à l'aide de solvants avec ou sans élévation de la température. L'ensemble électronique peut aussi être pressé à froid ou à chaud directement dans la matière qui se déforme localement ou dans une zone rendue malléable de manière à absorber le volume de la puce. Le but du procédé, comme dans le cas de substrats thermo-fusibles, est de conserver un positionnement précis sans jeu, ce qui signifie sans possibilité de mouvement de l'ensemble à l'intérieur de la cavité. Bien entendu, une telle cavité servant de logement à la puce peut aussi être formée dans un substrat thermo-fusible où un échauffement local peut faciliter l'enfoncement et le maintien de la puce dans le logement.

Des essais avec certains substrats non thermo-fusibles ont montré qu'un enfoncement direct à chaud de l'ensemble peut provoquer la combustion de la matière du substrat à l'endroit de la puce créant ainsi la cavité. La formation préalable de cette dernière n'est dans ce cas plus nécessaire.

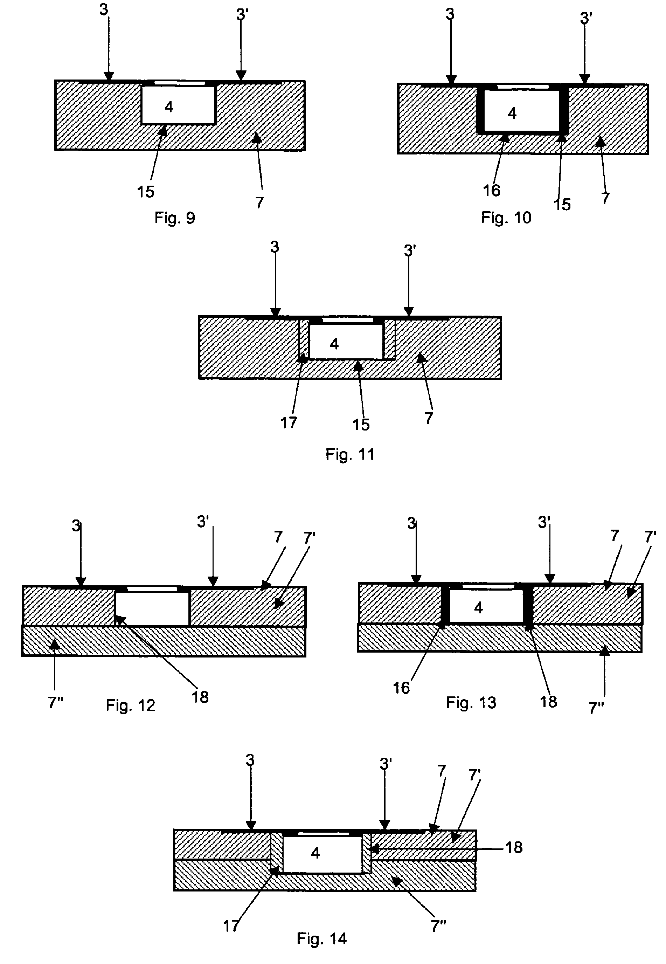

Plusieurs variantes du procédé illustrées par les figures 9 à 14 peuvent se présenter en fonction de la matière ou de la structure du substrat ou selon l'outillage à disposition, à savoir:
- La figure 9 montre la variante la plus simple où l'ensemble puce-segments est enfoncé directement dans la matière du substrat (7) soit à chaud, soit à froid à l'aide de solvants. Dans certains cas, afin de faciliter le placement de l'ensemble, un logement (15) est formé dans le substrat (7) avec des dimensions légèrement inférieures ou égales à celles de la puce (4). La profondeur du logement (15) correspond sensiblement à l'épaisseur de la puce (4) de sorte que sa face portant les segments (3, 3') affleure la surface du substrat (7). Ce logement (15) est créé de préférence lors d'une étape préalable au placement de l'ensemble puce-segments avec le dispositif de pose (6). Ce dernier enfonce ou chasse l'ensemble dans le logement (15) dans lequel il est maintenu grâce à la similitude des dimensions du logement (15) et de la puce (4). Afin de réduire la pression d'enfoncement, il est aussi envisageable de ramollir localement le pourtour du logement (15) à l'aide de solvants appropriés.
- la figure 10 montre le cas où les dimensions du logement (15) sont supérieures à celles de la puce (4) avec une profondeur correspondant sensiblement à l'épaisseur de la puce (4). Dans ce cas une substance de préférence adhésive (16), telle que par exemple une résine thermo-fusible, thermo-durcissable, ou photo-durcissable à la lumière ultra-violette ou toute autre colle appropriée, est déposée dans le logement (15). Le dispositif de pose (6) enfonce alors la puce (4) dans la substance adhésive (16) qui est répartie et refoulée dans l'espace libre laissé le long du contour de la puce (4). Ce remplissage permet le maintien d'une position stable de l'ensemble puce-segments après durcissement de la substance adhésive (16).
- la figure 11 montre le cas où la profondeur du logement (15) est inférieure à l'épaisseur de la puce (4) et avec des dimensions supérieures à celle de la puce (4). Le dispositif de pose (6) enfonce la puce de sorte que la face de la puce (4) portant les segments (3, 3') affleure la surface du substrat (7). Afin d'assurer cette mise à niveau sans une déformation excessive du substrat (7), celui-ci peut être ramolli (solvants ou échauffement) au niveau du logement (15) permettant aussi un refoulement (17) de la matière du substrat (7) dans l'espace libre entourant la puce (4). Cet espace ainsi comblé maintient la position de l'ensemble puce-segments dans le logement (15).
- Cette variante du procédé peut être combinée avec la précédente par un ajout de substance adhésive (16) dans le logement illustré par la figure 11 afin de compléter le remplissage de l'espace en fonction des dimensions de ce logement (15) par rapport à celles de la puce (4).
   Les figures 12 à 14 montrent une variante dans laquelle le substrat (7) et formé de deux couches (7', 7") superposées et placées l'une sur l'autre. La couche supérieure (7') comporte une fenêtre (18), c'est-à-dire un perçage à travers toute l'épaisseur de cette couche (7'). La fenêtre (18) est réalisée en général par étampage de la couche supérieure (7') du substrat avant la mise place de la couche inférieure (7"). La face inférieure de la fenêtre (18) est fermée par la couche inférieure (7") du substrat (7) de manière à former un logement servant à maintenir la puce (4) dans une position précise. Le laminage des deux couches du substrat s'effectue au cours d'une étape ultérieure après le placement de l'ensemble électronique dans le logement.
- La figure 12 illustre la variante où les dimensions de la fenêtre (18) sont inférieures ou égales à celles de la puce (4) et l'épaisseur de cette couche (7') équivaut à celle de la puce (4). Comme dans la variante de la figure 9, la puce (4) est enfoncée dans la fenêtre (18) et maintenue directement par les parois de la fenêtre (18). La face de la puce (4) portant les segments (3, 3') affleure la surface de la couche supérieure (7') du substrat (7).
- La figure 13 illustre la variante dans laquelle les dimensions de la fenêtre (18) sont plus grandes que celle de la puce (4) et l'épaisseur de la couche supérieure (7') correspond sensiblement à celle de la puce (4). Comme dans la variante de la figure 10, une substance adhésive (16) est déposée dans le logement formé par la fenêtre (18) de manière à combler l'espace entourant la puce (4) lorsque celle-ci est posée dans la fenêtre (18) et enfoncée dans la substance adhésive (16).
   Les variantes des figures 12 et 13, dans lesquelles l'épaisseur du substrat comportant la fenêtre est similaire à celle de la puce peuvent aussi se présenter sans le substrat inférieur. La puce est maintenue soit par les bords de la fenêtre, soit par une substance adhésive remplissant l'espace entre les bords de la fenêtre et la puce. Des couches supplémentaires de protection peuvent aussi être ajoutées au substrat au cours d'étapes ultérieures afin de recouvrir une ou les deux faces de la fenêtre.
- La figure 14 illustre la variante dans laquelle l'épaisseur de la couche supérieure (7') du substrat est plus faible que celle de la puce (4) avec les dimensions de la fenêtre (18) plus grandes que celles de la puce (4). Dans ce cas, comme dans celui de la figure 11, la puce (4) est enfoncée à travers la fenêtre (18) puis dans la couche inférieure (7") du substrat (7) ramollie de façon à refouler la matière (17) de cette couche (7") le long du contour de la puce (4). L'espace ainsi comblé autour de la puce (4) permet son maintien dans la fenêtre (18).
- Par analogie avec les variantes des figures 10 et 11, les variantes des figures 13 et 14 peuvent être combinées. Une substance adhésive (16) peut être ajoutée dans le logement illustré par la figure 14 de sorte à compléter le remplissage de l'espace libre autour de la puce (4) en fonction des dimensions de celle-ci par rapport à celles de la fenêtre (18).

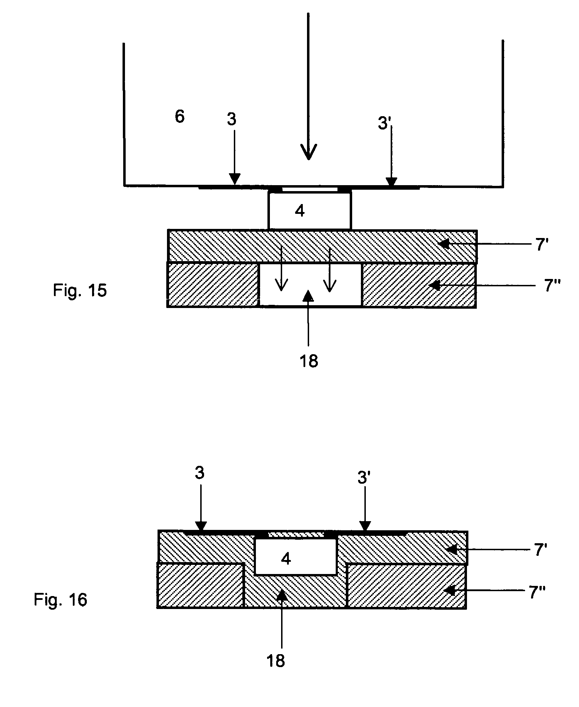

- La figures 15 et 16 montrent des variantes avec un substrat (7) en deux couches où la fenêtre (18) est découpée dans la couche inférieure (7") du substrat (7). L'ensemble puce (4) segments (3, 3') est enfoncé dans la couche supérieure (7') en regard de la fenêtre (18) de la couche inférieure (7") avec le dispositif de pose (6). La pression exercée par le dispositif de pose (6) permet de refouler la matière ramollie de la couche supérieure (7') dans la fenêtre (18) comme le montre la figure 16. Les segments (3, 3') affleurent la surface de la couche supérieure (7') comme dans les variantes des figures 9 à 14.

Les dimensions de la fenêtre (18) et l'épaisseur des couches (7', 7") du substrat (7) est déterminée entre autre par le volume de matière nécessaire pour remplir la fenêtre sans laisser apparaître, à la surface du substrat (7), une dépression ou une protubérance qui pourrait nuire à l'application de l'ensemble puce (4) segments (3, 3') intégré dans le substrat (7).

La figure 17 montre un exemple d'une réalisation effectuée selon le procédé de la présente invention. La portion de substrat (7) comprend une puce (4) munie de contacts (5, 5) connectés chacun à une extrémité d'un segment (3, 3') conducteur. L'autre extrémité de chaque segment (3, 3') conducteur est connectée à des pistes conductrices (21, 21') disposée sur le substrat (7). Le premier segment (3') provenant de la puce croise un ensemble pistes conductrices (21) en passant sur un premier segment isolant (20'). Le second segment conducteur (3) de la puce (4) est connecté sur une extrémité d'une piste (21'). Cette piste (21') est connectée à un troisième segment (3") conducteur aboutissant à une piste (21") distante en passant sur un second segment isolant (20) recouvrant un ensemble de pistes (21).

Le procédé de placement de ces différents éléments (segments conducteurs, isolants et puce) se résume comme suit:
- Étampage des trois segments conducteurs (3, 3', 3") et saisie par le dispositif de pose (6),
- Étampage des deux segments isolants (20, 20') et saisie par dispositif de pose (6),
- Saisie de la puce (4) de sorte que ses contacts (5, 5') se trouvent en regard des extrémités des segments conducteurs (3, 3') précédemment saisis et auxquels elles se connecteront au cours de l'étape d'enfoncement dans le substrat (7).
- Placement à une position prédéterminée sur le substrat (7) et enfoncement de tous les éléments saisis de manière que la face de la puce comportant les contacts ainsi que les segments conducteurs et isolants affleurent la surface du substrat.

## Revendications

1. Procédé d'agencement dans un support (7) d'au moins un ensemble électronique comprenant une puce (4), comportant au moins un contact électrique (5, 5') sur l'une de ses faces, et au moins un segment (3, 3') de piste conductrice connecté audit au moins un contact électrique (5, 5'), **caractérisé en ce qu'**il comprend les étapes suivantes:
- formation dudit au moins un segment (3, 3') de piste conductrice ayant un contour prédéterminé;
- saisie dudit au moins un segment (3, 3') de piste avec un dispositif de pose (6),
- saisie de la puce (4) avec le dispositif de pose (6) portant le segment (3, 3') de piste, de sorte qu'une extrémité dudit segment (3, 3') se place en regard d'un contact (5, 5') de la puce (4) ou s'applique contre ledit contact (5, 5');
- placement dudit ensemble électronique maintenu par ledit dispositif de pose (6) à une position déterminée relativement audit support (7); et
- pressage dudit ensemble électronique dans ledit support (7).

2. Procédé selon la revendication 1, **caractérisé en ce que** la saisie dudit au moins un segment (3, 3') par ledit dispositif de pose (6) est temporellement distincte de la saisie de ladite puce (4) par ce dispositif de pose (6), ce dernier maintenant ladite puce (4) dans une position donnée relativement audit au moins un segment (3, 3') par des moyens de retenue jusqu'au pressage dudit ensemble dans ledit support.(7).

3. Procédé selon l'une des revendications 1 ou 2, **caractérisé en ce que** lors de la saisie, ledit au moins un segment (3, 3') est saisi premièrement et ensuite ladite puce (4), la face de la puce (4) comportant ledit au moins un contact (5, 5') est dirigée vers le dispositif de pose (6) de manière que l'extrémité du segment (3, 3') soit placée en regard d'un contact (5, 5').

4. Procédé selon l'une des revendications 1 ou 2, **caractérisé en ce que** la connexion électrique entre ledit au moins un contact (5, 5') de la puce (4) et ledit au moins un segment (3. 3') est assuré par l'étape de pressage dudit ensemble dans ledit support (7).

5. Procédé selon l'une des revendications 1 ou 2, **caractérisé en ce qu'**une opération de soudure dudit segment (3, 3') sur ledit au moins un contact (5, 5') de la puce (4) est effectuée par le dispositif de pose (6) qui est équipé de moyens de soudure.

6. Procédé selon l'une des revendications 1 ou 2, **caractérisé qu'**une opération de soudure dudit au moins un segment (3, 3') sur ledit au moins un contact (5, 5') de la puce (4) est effectuée à l'aide d'un dispositif de soudage séparé du dispositif de pose (6) soit avant l'étape de saisie dudit ensemble électronique par ledit dispositif de pose (6), soit après l'étape de pressage dudit ensemble dans ledit support.(7).

7. Procédé selon l'une des revendications 1 ou 2, **caractérisé en ce qu'**il comporte une étape de déposition de colle conductrice sur les contacts (5, 5') de la puce (4) précédant la saisie de ladite puce (4) par le dispositif de pose (6).

8. Procédé selon l'une des revendications 1 ou 2, **caractérisé en ce qu'**il comporte une étape de déposition de colle conductrice sur l'extrémité de chaque segment (3, 3') destinée à être appliquée contre un contact (5, 5') de la puce (4).

9. Procédé selon la revendication 1, **caractérisé en ce que** ledit au moins un segment (3, 3') définit une antenne.

10. Procédé selon la revendication 9, **caractérisé en ce que** ladite antenne est formée soit par deux segments (3, 3') connectés respectivement à deux contacts (5, 5') de ladite puce (4), soit par une boucle dont deux extrémités sont connectées respectivement à deux contacts (5, 5') de ladite puce (4).

11. Procédé selon la revendication 1, **caractérisé en ce que** l'autre extrémité du segment (3, 3') est destinée à être connectée à une piste conductrice disposée sur ledit support (7).

12. Procédé selon la revendication 1, **caractérisé en ce que** ledit au moins un segment (3, 3') de piste est découpé dans une feuille (2) de matériau conducteur.

13. Procédé selon la revendication 1, **caractérisé en ce qu'**au moins un segment isolant (20, 20') est obtenu à partir d'un film isolant puis appliqué contre ledit au moins un segment (3, 3') de piste, chaque segment isolant (20, 20') formant une zone isolante (13, 13') sur le segment de piste (3, 3') auquel il est associé.

14. Procédé la revendication 1, **caractérisé en ce qu'**au moins un segment de piste conductrice supplémentaire (3") est également saisi et déposé sur ledit support (7) par ledit dispositif de pose (6), ce segment supplémentaire (3") formant une liaison électrique entre une première piste (21') et une deuxième piste (21") disposées sur ledit support (7).

15. Procédé selon la revendication 14, **caractérisé en ce qu'**il est prévu que ledit segment supplémentaire (3") passe par dessus un ensemble de pistes (21), un segment isolant (20, 20') étant agencé entre cet ensemble de pistes (21) et ledit segment supplémentaire (3").

16. Procédé selon la revendication 15, **caractérisé en ce que** ledit segment isolant (20, 20') associé audit segment supplémentaire (3") est également saisi et déposé par ledit dispositif de pose (6).

17. Procédé selon la revendication 1, **caractérisé en ce que** ledit ensemble électronique est introduit dans ledit support (7) de manière que la surface de la puce (4) portant les contacts (5, 5') affleure sensiblement la surface du support (7), et **en ce que** ledit au moins un segment (3, 3') soit appliqué contre cette surface du support (7).

18. Procédé selon la revendication 17, **caractérisé en ce qu'**il est prévu, suite au pressage dudit ensemble dans ledit support.(7), un apport d'une feuille isolante (9) de protection sur tout ou partie de ladite surface du support (7).

19. Procédé selon la revendication 12, **caractérisé en ce que** la feuille (2) de matériau conducteur comporte un film isolant (12, 12') appliqué contre sa face inférieure.

20. Procédé selon la revendication 19, **caractérisé en ce qu'**au moins un segment (3, 3') est obtenu à partir de ladite feuille (2) de manière à comporter une zone isolante (13, 13') sur la partie médiane de sa face inférieure destinée à être appliquée contre le support (7), les extrémités de ce segment (3, 3') étant dégagées de la zone isolante (13, 13').

21. Procédé selon la revendication 19 ou 20, **caractérisé en ce que** le film (12, 12') isolant est enduit d'une colle.

22. Procédé selon la revendication 21 **caractérisé en ce que** lors du placement de l'ensemble sur le support (7), le dispositif de pose (6) échauffe ledit au moins un segment (3, 3') en des points (14, 14') situés en regard de la zone isolante (13, 13') entraînant une activation de la colle et le maintien du segment (3, 3') sur le support (7).

23. Procédé selon la revendication 1, **caractérisé en ce qu'**il comprend une étape préliminaire de formation, dans le support (7), d'une cavité destinée à servir de logement (15) à la puce (4) de l'ensemble électronique.

24. Procédé selon la revendication 23 dans lequel les dimensions du logement (15) équivalent à celle de la puce (4) et la profondeur dudit logement (15) correspond sensiblement à l'épaisseur de la puce (4), **caractérisé en ce qu'**il comporte une étape de ramollissement du support (7) au niveau dudit logement (15) précédant une étape d'enfoncement de la puce (4) dans le logement (15) de manière que la face de ladite puce (4) portant les segments (3, 3') affleure sensiblement la surface du support.

25. Procédé selon la revendication 23 dans lequel les dimensions du logement (15) sont supérieures à celle de la puce (4) et la profondeur dudit logement (15) correspond sensiblement à l'épaisseur de la puce (4), **caractérisé en ce qu'**il comporte une étape de déposition d'une substance adhésive (16) dans le logement (15) précédant le pressage dudit ensemble dans, ledit support.(7) de sorte que l'espace libre entourant la puce (4) placée dans le logement (15) est comblé par le refoulement de ladite substance adhésive et **en ce que** la face de ladite puce (4) portant les segments (3, 3') affleure sensiblement la surface du support (7).

26. Procédé selon la revendication 23 dans lequel les dimensions du logement (15) sont supérieures à celle de la puce (4) et la profondeur dudit logement (15) inférieure à l'épaisseur de la puce (4), **caractérisé en ce qu'**il comporte une étape de ramollissement du support (7) au niveau dudit logement (15) avant et/ou pendant une étape d'enfoncement de la puce (4) dans le logement (15) de manière que la face de ladite puce (4) portant les segments (3, 3') affleure sensiblement la surface du support (7), l'espace entourant la puce (4) placée dans le logement (15) étant au moins partiellement comblé par un refoulement (17) de matière du support (7).

27. Procédé selon la revendication 26, **caractérisé en ce qu'**une substance adhésive (16) est déposée dans le logement (15) avant l'étape d'enfoncement de la puce (4) de sorte que ladite substance (16) complète le remplissage de l'espace entourant la puce (4) placée dans le logement (15).

28. Procédé selon la revendication 1, **caractérisé en ce qu'**il comprend des étapes préliminaires de constitution d'un support (7) formé par la superposition d'au moins deux couches (7', 7") l'une sur l'autre, et de formation d'une fenêtre (18) dans la couche supérieure (7'), la couche inférieure (7") fermant la partie inférieure de la fenêtre (18), ladite fenêtre (18) définissant un logement destiné à recevoir la puce (4) de l'ensemble électronique.

29. Procédé selon la revendication 28 dans lequel les dimensions de la fenêtre (18) sont équivalentes à celles de la puce (4) et l'épaisseur de la couche supérieure (7') du support (7) correspond sensiblement à l'épaisseur de la puce (4), **caractérisé en ce qu'**il comporte une étape de ramollissement du support (7) au niveau de ladite fenêtre (18) avant et/ou pendant une étape d'enfoncement de la puce (4) dans la fenêtre (18) de sorte que la face de ladite puce (4) portant les segments (3, 3') affleure sensiblement la surface du support (7).

30. Procédé selon la revendication 28 dans lequel les dimensions de la fenêtre (18) sont supérieures à celles de la puce (4) et l'épaisseur de la couche supérieure (7') du support (7) correspond sensiblement à l'épaisseur de la puce (4), **caractérisé en ce qu'**il comporte une étape de déposition d'une substance adhésive (16) dans le logement formé par la fenêtre (18) précédant le pressage dudit ensemble dans ledit support.(7) de sorte que l'espace libre entourant la puce (4) placée dans la fenêtre (18) soit comblé par le refoulement (17) de ladite substance adhésive (16) et que la face de ladite puce (4) portant les segments (3, 3') affleure sensiblement la surface du support (7).

31. Procédé selon la revendication 28 dans lequel les dimensions de la fenêtre (18) sont supérieures à celles de la puce (4) et l'épaisseur de la couche supérieure (7') du support (7) est plus faible que l'épaisseur de la puce (4), **caractérisé en ce qu'**il comporte une étape de ramollissement du support (7) au niveau de ladite fenêtre (18) avant et/ou pendant une étape d'enfoncement de la puce (4) dans le logement formé par la fenêtre (18) de manière que la face de ladite puce (4) portant les segments (3, 3') affleure sensiblement la surface du support (7), l'espace entourant la puce (4) placée dans la fenêtre (18) étant comblé au moins en partie par le refoulement (17) de la matière de la couche inférieure (7") du support (7).

32. Procédé selon la revendication 31, **caractérisé en ce qu'**une substance adhésive (16) est déposée dans le logement formé par la fenêtre (18) avant l'étape d'enfoncement de la puce (4) de sorte que ladite substance (16) complète le remplissage de l'espace entourant la puce (4) placée dans ledit logement.

33. Procédé selon la revendication 1, **caractérisé en ce qu'**il comprend des étapes préliminaires de constitution d'un support (7) formé par la superposition d'au moins deux couches (7', 7") l'une sur l'autre, et de formation d'une fenêtre (18) dans la couche inférieure (7"), la couche supérieure (7') fermant la fenêtre (18), l'ensemble électronique étant enfoncé dans la couche supérieure (7') en regard de la fenêtre (18) de la couche inférieure (7") avec le dispositif de pose (6), la pression exercée par ledit dispositif de pose (6) refoulant la matière ramollie de la couche supérieure (7') dans la fenêtre (18), et les segments (3, 3') et la puce (4) de l'ensemble électronique affleurant finalement la surface de la couche supérieure (7')

34. Dispositif de pose (6) destiné à placer sur un support (7) un ensemble électronique comprenant une puce (4) munie d'au moins un contact (5, 5') électrique connecté à un segment (3, 3') dé piste conductrice, ledit dispositif étant équipé de moyens de positionnement et de pressage dudit ensemble dans ledit support (7) et étant **caractérisé en ce qu'**il comporte une tête pourvue de moyens de retenue d'au moins un segment (3, 3') de piste conductrice et également de moyens de retenue d'une puce (4) qui est saisie de manière que chaque segment (3, 3') de piste soit situé en regard ou appliqué contre au moins un contact (5, 5') de la puce (4).

35. Dispositif selon la revendication 34, **caractérisé en ce que** les moyens de retenue dudit au moins un segment de piste (3, 3') sont constitués d'orifices (10, 10') d'aspiration d'air créant un vacuum sur l'une des faces dudit au moins un segment (3, 3') et maintenant ainsi ledit segment (3, 3') contre ladite tête.

36. Dispositif selon la revendication 35, **caractérisé en ce que** les moyens de retenue de la puce (4) comprennent au moins un orifice (11) d'aspiration d'air situé dans une zone centrale de la tête dudit dispositif au voisinage d'au moins une extrémité de segment de piste (3, 3') maintenu par les orifices (10, 10') correspondants.

37. Dispositif selon la revendication 34, **caractérisé en ce que** les moyens de retenue de la puce (4) comprennent des éléments adhésifs.

38. Dispositif selon la revendication 34 **caractérisé en ce que** la tête comporte des moyens de soudure dudit au moins un segment (3, 3') de piste conductrice sur au moins un contact (5, 5') de la puce (4).

## Claims

1. Process for applying into a support (7), of at least one electronic assembly comprising a chip (4) including at least one electric contact (5, 5') on one of its faces, and at least one segment (3, 3') of conductive track connected to said at least electric contact (5, 5'), **characterized in that** it includes the following steps:
- forming said at least one segment (3, 3') of conductive track having a predetermined outline,
- seizing the at least one track segment (3, 3') and of the chip (4) with a placement device (6),
- seizing the chip (4) with the placement device (6) carrying the track segment (3, 3') in order to place one end of said segment (3, 3') facing a contact (5, 5') of the chip (4) or applying on said contact (5, 5').
- placing said electronic assembly maintained by said placement device (6) at a position predetermined relatively to said support (7),
- pressing said electronic assembly into said support (7).

2. Process according to claim 1 **characterized in that** the seizing of said at least one segment (3, 3') by said placement device (6) is temporally distinct from the seizing of said chip (4) by this placement device (6) maintaining with holding means said chip (4) in a position given relatively to said at least one segment (3, 3') until the step of pressing said assembly into said support (7).

3. Process according to anyone of the claim 1 or 2 **characterized in that** during seizing, said at least one segment (3, 3') is seized first and then said chip (4), the face of the chip (4) including said at least one contact (5, 5') is directed towards the placement device (6) so that the end of the segment (3, 3') faces a contact (5, 5').

4. Process according to anyone of the claim 1 or 2 **characterized in that** the electric connection between the at least one contact (5, 5') of the chip (4) and said at least one segment (3, 3') is ensured by the step of pressing said electronic assembly into said support (7).

5. Process according to anyone of the claim 1 or 2 **characterized in that** a welding operation of the segment (3, 3') on the contact (5, 5') of the chip (4) is carried out with the placement device (6) provided with welding means.

6. Process according to anyone of the claim 1 or 2 **characterized in that** an operation of welding said at least one segment (3, 3') on said at least one contact (5, 5') of the chip (4) is carried out with a welding device separated from the placement device (6) either before the step of seizing said electronic assembly by said placement device (6), or after the step of pressing said electronic assembly into said support (7)

7. Process according to anyone of the claim 1 or 2 **characterized in that** it includes a step for applying conductive adhesive on the contacts (5, 5') of the chip (4) prior to the seizing of said chip (4) by the placement device (6).

8. Process according to anyone of the claim 1 or 2 **characterized in that** it includes a step of applying conductive adhesive on the end of each segment (3, 3') intended to be applied against a contact (5, 5') of the chip (4).

9. Process according to claim 1 **characterized in that** said at least one segment (3, 3') defines an antenna.

10. Process according to claim 10 **characterized in that** said antenna is made up either of two segments (3, 3') connected respectively to two contacts (5, 5') of said chip (4), or of a loop having two ends connected respectively to two contacts (5, 5') of said chip (4).

11. Process according to claim 1 **characterized in that** the other end of the segment (3, 3') intended to be connected to a conductive track arranged on said support (7).

12. Process according to claim 1 **characterized in that** said at least one track segment (3, 3') is cut out from a sheet (2) of conductive material.

13. Process according to claim 1 **characterized in that** at least one insulating segment (20, 20') is obtained from an insulating film and then applied against said at least track segment (3, 3'), each insulating segment (20, 20') forming an insulating area (13, 13') on the track segment (3, 3') to which it is associated.

14. Process according to claim 1 **characterized in that** at least one supplementary conductive track segment (3") is also seized and placed on said support (7) by said placement device (6), this supplementary segment (3") forming an electrical link between a first track (21') and a second track (21 ") arranged on said support (7).

15. Process according to claim 15 **characterized in that** said supplementary segment (3") crosses a set of tracks (21), an insulating segment (20, 20') being arranged between said set of tracks (21) and said supplementary segment (3").

16. Process according to claim 15 **characterized in that** said insulating segment (20, 20') associated to said supplementary segment (3") is also seized and placed by said placement device (6).

17. Process according to claim 1 **characterized in that** said electronic assembly is embedded in said support (7) in such a way that the surface of the chip (4) including the contacts (5, 5') is substantially level with the surface of the support (7) and **in that** said at least one segment (3, 3') is applied against the surface of the support (7).

18. Process according to claim 17 **characterized in that**, subsequently to said embedding of said electronic assembly into said support (7), an insulating protection sheet (9) is added on all or part of said surface of the support (7).

19. Process according to claim 12 **characterized in that** the sheet (2) of conductive material includes an insulating film (12, 12') applied against its lower face.

20. Process according to claim 19 **characterized in that** the segment (3, 3') is obtained from said sheet (2) in order to include an insulating area (13, 13') on the central part of its lower face intended to be applied against the support (7), the ends of said segment (3, 3') being released from the insulating area (13, 13').

21. Process according to claim 19 or 20 **characterized in that** the insulating film (12, 12') is coated with adhesive.

22. Process according to claim 22 **characterized in that** during the placement of the assembly on the support (7), the placement device (6) heats said at least one track segment (3, 3') at points (14, 14') facing the insulating area (13, 13') leading to an activation of the adhesive and the holding of the segment (3, 3') on the support (7).

23. Process according to claim 1 **characterized in that** it includes a preliminary step of formation, in the support (7), of a cavity (15) for fitting the chip (4) of the electronic assembly.

24. Process according to claim 23 wherein the dimensions of the cavity (15) are equivalent to those of the chip (4) and the depth of said cavity (15) corresponds substantially to the thickness of the chip (4), **characterized in that** it includes a step of softening the support (7) near said cavity (15) prior to a step of embedding of the chip (4) into the cavity (15) so that the face of said chip (4) carrying the segments (3, 3') is substantially level with the surface of the support (7).

25. Process according to claim 23 wherein the dimensions of the cavity (15) are larger than those of the chip (4) and the depth of said cavity (15) corresponds substantially to the thickness of the chip (4), **characterized in that** it includes a step of applying an adhesive substance (16) in the cavity (15) prior to the pressing the of chip (4) in said support (7) so that the free space surrounding the chip (4) placed in the cavity (15) is filled by the discharging of said adhesive substance (16) and **in that** the face of said chip (4) carrying the segments (3, 3') is substantially level with the surface of the support (7).

26. Process according to claim 23 wherein the dimensions of the cavity (15) are larger than those of the chip (4) and the depth of said cavity (15) is smaller than the thickness of the chip (4), **characterized in that** it includes a step of softening the support (7) near said cavity (15) before and/or during a step of embedding of the chip (4) into the cavity (15) so that the face of said chip (4) carrying the segments (3, 3') is substantially level with the surface of the support (7), the space surrounding the chip (4) placed in the cavity (15) being at least partially filled by the discharging (17) of the material of the support (7).

27. Process according to claim 26 **characterized in that** an adhesive substance (16) is applied into the cavity (15) before the step of embedding of the chip (4) so that said substance (16) completes the filling of the space surrounding the chip (4) placed in the cavity (15).

28. Process according to claim 1 **characterized in that** it includes preliminary steps of building a support (7) formed by the superimposing of at least two layers (7', 7") one on top of the other, and of formation of a window (18) in the upper layer (7'), the lower layer (7") closing the lower part of the window (18), said window (18) defining a cavity intended to receive the chip (4) of the electronic assembly.

29. Process according to claim 28 wherein the dimensions of the window (18) are equivalent to those of the chip (4) and the thickness of the upper layer (7') of the support (7) corresponds substantially to the thickness of the chip (4), **characterized in that** it includes a step of softening the support (7) near said window (18) before and/or during a step of embedding of the chip (4) into the window (18) so that the face of said chip (4) carrying the segments (3, 3') is substantially level on the surface of the support (7).

30. Process according to claim 28 wherein the dimensions of the window (18) are larger than those of the chip (4) and the thickness of the upper layer (7') of the support (7) corresponds substantially to the thickness of the chip (4), **characterized in that** it includes a step of application of an adhesive substance (16) into the cavity formed by the window (18) prior to the pressing of the chip (4) into said support (7) so that the free space surrounding the chip (4) placed in the window (18) is filled by the discharging (17) of said adhesive substance (16) and **in that** the face of said chip (4) carrying the segments (3, 3') is substantially level with the surface of the support (7).

31. Process according to claim 28 wherein the dimensions of the window (18) are larger than those of the chip (4) and the thickness of the upper layer (7') of the support (7) is smaller than the thickness of the chip (4), **characterized in that** it includes a step of softening the support (7) near said window (18) before and/or during a step of embedding of the chip (4) into the cavity formed by the window (18) so that the face of said chip (4) carrying the segments (3, 3') is substantially level with the surface of the support (7), the space surrounding the chip (4) placed in window (18) being filled at least partially by the discharging (17) of the material of the lower layer (7") of the support (7).

32. Process according to claim 31 **characterized in that** an adhesive substance (16) is applied into the cavity formed by the window (18) prior to the step of embedding of the chip (4) so that said adhesive substance (16) completes the filling of the space surrounding the chip (4) placed in said cavity.

33. Process according to claim 1 **characterized in that** it includes preliminary steps of building a support (7) formed by the superimposing of at least two layers (7', 7") one on top of the other, and the formation of a window (18) in a lower layer (7'), the upper layer (7') closing the window (18), the electronic assembly being embedded into the upper layer (7') facing the window (18) of the lower layer (7") with the placement device (6), the pressure exerted by said placement device (6) discharging the softened material of the upper layer (7') into the window (18), the segments (3, 3') and the chip (4) of the electronic assembly being substantially level with the surface of the upper layer (7')

34. Placement device (6) intended to place on a support (7) an electronic assembly comprising a chip (4) provided with at least one electric contact (5, 5') connected to a conductive track segment (3, 3'), said device being provided with means for positioning and for pressing the electronic assembly into said support (7) is **characterized in that** it comprises a head provided with means for holding of at least one conductive track segment (3, 3') and also means for holding a chip (4) which is seized so that each track segment (3, 3') is positioned facing or applied against at least one contact (5, 5') of the chip (4).

35. Device according to claim 34 **characterized in that** the means for holding said at least one track segment (3, 3') consist of air suction openings (10, 10') creating a vacuum on one of the faces of said at least one track segment (3, 3') and maintaining thus said segment (3, 3') against said head..

36. Device according to claim 35 **characterized in that** the means for holding the chip (4) comprise at least one air suction opening (11) located in a central area of the head of said device close to at least one end of the track segment (3, 3') held by corresponding openings (10, 10').

37. Device according to claim 34 **characterized in that** the means for holding the chip (4) comprise adhesive elements.

38. Device according to claim 34 **characterized in that** the head includes means for welding the track segment (3, 3') on a contact (5, 5') of the chip (4).

## Patentansprüche

1. Verfahren, in einem Träger (7) zumindest eine elektronische Baugruppe anzuordnen, die einen Chip (4) umfasst, der zumindest einen elektrischen Anschluss (5, 5') auf einer seiner Seiten sowie zumindest einen mit dem zumindest einen elektrischen Anschluss (5, 5') verbundenen Leiterbahnabschnitt (3, 3') aufweist, **dadurch gekennzeichnet, dass** es die folgenden Schritte umfasst:
- Bildung des zumindest einen Leiterbahnabschnitts (3, 3') mit einer vorbestimmten Kontur;
- Ergreifen des zumindest einen Bahnabschnitts (3, 3') mit einer Verlegevorrichtung (6),
- Ergreifen des Chips (4) mit der Verlegevorrichtung (6), die den Bahnabschnitt (3, 3') trägt, in der Weise, dass ein Ende des Abschnitts (3, 3') einem Anschluss (5, 5') des Chips (4) gegenüber aufgesetzt oder an den Anschluss (5, 5') angedrückt wird;
- Aufsetzen der durch die Verlegevorrichtung (6) gehaltenen elektronischen Baugruppe an einer bezüglich des Trägers (7) festgelegten Position; und
- Einpressen der elektronischen Baugruppe in den Träger (7).

2. Verfahren nach Anspruch 1, **dadurch gekennzeichnet, dass** das Ergreifen des zumindest einen Abschnitts (3, 3') durch die Verlegevorrichtung (6) zeitlich getrennt vom Ergreifen des Chips (4) durch diese Verlegevorrichtung (6) erfolgt, wobei letztere den Chip (4) bis zum Einpressen der Baugruppe in den Träger (7) durch Haltemittel in einer bezüglich des zumindest einen Abschnitts (3, 3') vorgegebenen Position bewahrt.

3. Verfahren nach einem der Ansprüche 1 oder 2, **dadurch gekennzeichnet, dass** während des Ergreifens zuerst der zumindest eine Abschnitt (3, 3') und danach der Chip (4) ergriffen wird, wobei die Seite des Chips (4), die den zumindest einen Anschluss (5, 5') aufweist, so zur Verlegevorrichtung (6) hin ausgerichtet ist, dass das Ende des Abschnitts (3, 3') einem Anschluss (5, 5') gegenüber aufgesetzt wird.

4. Verfahren nach einem der Ansprüche 1 oder 2, **dadurch gekennzeichnet, dass** die elektrische Verbindung zwischen dem zumindest einen Anschluss (5, 5') des Chips (4) und dem zumindest einen Abschnitt (3, 3') durch den Schritt des Einpressens der Baugruppe in den Träger (7) gewährleistet wird.

5. Verfahren nach einem der Ansprüche 1 oder 2, **dadurch gekennzeichnet, dass** eine Operation des Anschweissens des Abschnitts (3, 3') an den zumindest einen Anschluss (5, 5') des Chips (4) durch die Verlegevorrichtung (6) ausgeführt wird, die mit Mitteln zum Schweissen ausgerüstet ist.

6. Verfahren nach einem der Ansprüche 1 oder 2, **dadurch gekennzeichnet, dass** eine Operation des Anschweissens des zumindest einen Abschnitts (3, 3') an den zumindest einen Anschluss (5, 5') des Chips (4) mit Hilfe einer von der Verlegevorrichtung (6) getrennten Schweissvorrichtung entweder vor dem Schritt des Ergreifens der elektronischen Baugruppe durch die Verlegevorrichtung (6) oder nach dem Schritt des Einpressens der Baugruppe in den Träger (7) ausgeführt wird.

7. Verfahren nach einem der Ansprüche 1 oder 2, **dadurch gekennzeichnet, dass** es einen Schritt des Aufbringens eines leitfähigen Klebers auf die Anschlüsse (5, 5') des Chips (4) aufweist, der dem Ergreifen des Chips (4) durch die Verlegevorrichtung (6) vorausgeht.

8. Verfahren nach einem der Ansprüche 1 oder 2, **dadurch gekennzeichnet, dass** es einen Schritt des Aufbringens eines leitfähigen Klebers auf das Ende jedes Abschnitts (3, 3') aufweist, das dafür bestimmt ist, an einen Anschluss (5, 5') des Chips (4) angedrückt zu werden.

9. Verfahren nach Anspruch 1, **dadurch gekennzeichnet, dass** der zumindest eine Abschnitt (3, 3') eine Antenne definiert.

10. Verfahren nach Anspruch 9, **dadurch gekennzeichnet, dass** die Antenne entweder aus zwei Abschnitten (3, 3'), die mit zwei entsprechenden Anschlüssen (5, 5') des Chips (4) verbunden sind, oder aus einer Schleife gebildet wird, deren zwei Enden mit zwei entsprechenden Anschlüssen (5, 5') des Chips (4) verbunden sind.

11. Verfahren nach Anspruch 1, **dadurch gekennzeichnet, dass** das andere Ende des Abschnitts (3, 3') dafür bestimmt ist, mit einer auf dem Träger (7) angeordneten Leiterbahn verbunden zu werden.

12. Verfahren nach Anspruch 1, **dadurch gekennzeichnet, dass** der zumindest eine Bahnabschnitt (3, 3') aus einer Folie (2) aus leitfähigem Material herausgeschnitten wird.

13. Verfahren nach Anspruch 1, **dadurch gekennzeichnet, dass** zumindest ein isolierender Abschnitt (20, 20') aus einer Isolierfolie gewonnen und dann an den zumindest einen Bahnabschnitt (3, 3') angedrückt wird, wobei jeder isolierende Abschnitt (20, 20') einen isolierenden Bereich (13, 13') auf dem Bahnabschnitt (3, 3') bildet, mit dem er verknüpft ist.

14. Verfahren nach Anspruch 1, **dadurch gekennzeichnet, dass** zumindest ein zusätzlicher Leiterbahnabschnitt (3") ebenfalls durch die Verlegevorrichtung (6) ergriffen und auf den Träger (7) aufgebracht wird, wobei dieser zusätzliche Abschnitt (3") eine elektrische Verbindung zwischen einer ersten Bahn (21') und einer zweiten Bahn (21 ") bildet, die auf dem Träger (7) angeordnet sind.

15. Verfahren nach Anspruch 14, **dadurch gekennzeichnet, dass** vorgesehen ist, dass der zusätzliche Abschnitt (3") über eine Gruppe von Bahnen (21) hinweg führt, wobei ein isolierender Abschnitt (20, 20') zwischen dieser Gruppe von Bahnen (21) und dem zusätzlichen Abschnitt (3") angeordnet ist.

16. Verfahren nach Anspruch 15, **dadurch gekennzeichnet, dass** der mit dem zusätzlichen Abschnitt (3") verknüpfte isolierende Abschnitt (20, 20') ebenfalls durch die Verlegevorrichtung (6) ergriffen und aufgebracht wird.

17. Verfahren nach Anspruch 1, **dadurch gekennzeichnet, dass** die elektronische Baugruppe so in den Träger (7) eingeführt wird, dass die Oberfläche des Chips (4), die die Anschlüsse (5, 5') trägt, im Wesentlichen mit der Oberfläche des Trägers (7) bündig ist, und **dadurch**, dass der zumindest eine Abschnitt (3, 3') an diese Oberfläche des Trägers (7) angedrückt wird.

18. Verfahren nach Anspruch 17, **dadurch gekennzeichnet, dass** vorgesehen ist, nach Einpressen der Baugruppe in den Träger (7) eine isolierende Schutzfolie (9) auf die gesamte oder einen Teil der Oberfläche des Trägers (7) aufzubringen.

19. Verfahren nach Anspruch 12, **dadurch gekennzeichnet, dass** die Folie (2) aus leitendem Material eine an ihrer Unterseite angebrachte isolierende Schicht (12, 12') aufweist.

20. Verfahren nach Anspruch 19, **dadurch gekennzeichnet, dass** zumindest ein Abschnitt (3, 3') so aus der Folie (2) gewonnen wird, dass er auf dem mittleren Teil seiner Unterseite, die dafür bestimmt ist, an den Träger (7) angedrückt zu werden, einen isolierenden Bereich (13, 13') aufweist, wobei die Enden dieses Abschnitts (3, 3') vom isolierenden Bereich (13, 13') beabstandet sind.

21. Verfahren nach Anspruch 19 oder 20, **dadurch gekennzeichnet, dass** die isolierende Schicht (12, 12') mit einem Kleber bestrichen ist.

22. Verfahren nach Anspruch 21, **dadurch gekennzeichnet, dass** während des Aufsetzens der Baugruppe auf den Träger (7) die Verlegevorrichtung (6) den zumindest einen Abschnitt (3, 3') an Punkten (14, 14') erhitzt, die dem isolierenden Bereich (13, 13') gegenüber liegen, was eine Aktivierung des Klebers und einen Halt des Abschnitts (3, 3') auf dem Träger (7) zur Folge hat.

23. Verfahren nach Anspruch 1, **dadurch gekennzeichnet, dass** es einen vorausgehenden Schritt umfasst, bei dem im Träger (7) eine Aushöhlung gebildet wird, die dazu bestimmt ist, als Lager (15) des Chips (4) der elektronischen Baugruppe zu dienen.

24. Verfahren nach Anspruch 23, bei dem die Abmessungen des Lagers (15) denen des Chips (4) entsprechen und die Tiefe des Lagers (15) im Wesentlichen der Dicke des Chips (4) entspricht, **dadurch gekennzeichnet, dass** es einen Schritt des Erweichens des Trägers (7) am Ort des Lagers (15) aufweist, der einem Schritt des Eindrückens (4) des Chips (4) in das Lager (15) vorausgeht, dergestalt, dass die Seite des Chips (4), die die Abschnitte (3, 3') trägt, im Wesentlichen mit der Oberfläche des Trägers bündig ist.

25. Verfahren nach Anspruch 23, bei dem die Abmessungen des Lagers (15) grösser als die des Chips (4) sind und die Tiefe des Lagers (15) im Wesentlichen der Dicke des Chips (4) entspricht, **dadurch gekennzeichnet, dass** es einen Schritt des Einbringens eines Klebstoffs (16) in das Lager (15) aufweist, der dem Einpressen der Baugruppe in den Träger (7) vorausgeht, dergestalt, dass der freie Raum, der den in das Lager (7) eingesetzten Chip (4) umgibt, durch Fliessen des Klebstoffs aufgefüllt wird, und **dadurch**, dass die Seite des Chips (4), die die Abschnitte (3, 3') trägt, im Wesentlichen mit der Oberfläche des Trägers (7) bündig ist.

26. Verfahren nach Anspruch 23, bei dem die Abmessungen des Lagers (15) grösser als die des Chips (4) sind und die Tiefe des Lagers (15) geringer als die Dicke des Chips (4) ist, **dadurch gekennzeichnet, dass** es einen Schritt des Erweichens des Trägers (7) am Ort des Lagers (15) vor und/oder während eines Schritts des Eindrückens des Chips (4) in das Lager (15) aufweist, dergestalt, dass die Seite des Chips (4), die die Abschnitte (3, 3') trägt, im Wesentlichen mit der Oberfläche des Trägers (7) bündig ist, wobei der Raum, der den in das Lager (7) eingesetzten Chip (4) umgibt, zumindest teilweise durch Fliessen (17) des Materials des Trägers (7) aufgefüllt wird.

27. Verfahren nach Anspruch 26, **dadurch gekennzeichnet, dass** ein Klebstoff (16) vor dem Schritt des Eindrückens des Chips (4) in das Lager (15) eingebracht wird, dergestalt, dass der Klebstoff (16) die Auffüllung des Raumes, der den in das Lager (15) eingesetzten Chip (4) umgibt, vervollständigt.

28. Verfahren nach Anspruch 1, **dadurch gekennzeichnet, dass** es vorausgehende Schritte des Aufbaus eines Trägers (7), der durch das Übereinanderlegen von zumindest zwei Schichten (7', 7") gebildet wird, sowie der Bildung eines Fensters (18) in der oberen Schicht (7') umfasst, wobei die untere Schicht (7") den unteren Teil des Fensters (18) abschliesst und das Fenster (18) ein Lager definiert, das dafür bestimmt ist, den Chip (4) der elektronischen Baugruppe aufzunehmen.

29. Verfahren nach Anspruch 28, bei dem die Abmessungen des Fensters (18) denen des Chips (4) entsprechen und die Dicke der oberen Schicht (7') des Trägers (7) im Wesentlichen der Dicke des Chips (4) entspricht, **dadurch gekennzeichnet, dass** es einen Schritt des Erweichens des Trägers (7) am Ort des Fensters (18) vor und/oder während eines Schrittes des Eindrückens (4) des Chips (4) in das Fenster (18) aufweist, dergestalt, dass die Seite des Chips (4), die die Abschnitte (3, 3') trägt, im Wesentlichen mit der Oberfläche des Trägers (7) bündig ist.

30. Verfahren nach Anspruch 28, bei dem die Abmessungen des Fensters (18) grösser als die des Chips (4) sind und die Dicke der oberen Schicht (7') des Trägers (7) im Wesentlichen der Dicke des Chips (4) entspricht, **dadurch gekennzeichnet, dass** es einen Schritt des Einbringens eines Klebstoffs (16) in das durch das Fenster (18) gebildete Lager aufweist, der dem Einpressen der Baugruppe in den Träger (7) vorausgeht, dergestalt, dass der freie Raum, der den in das Fenster (18) eingesetzten Chip (4) umgibt, durch das Fliessen (17) des Klebstoffs (16) aufgefüllt wird, und die Seite des Chips (4), die die Abschnitte (3, 3') trägt, im Wesentlichen mit der Oberfläche des Trägers (7) bündig ist.

31. Verfahren nach Anspruch 28, bei dem die Abmessungen des Fensters (18) grösser als die des Chips (4) sind und die Dicke der oberen Schicht (7') des Trägers (7) geringer als die Dicke des Chips (4) ist, **dadurch gekennzeichnet, dass** es einen Schritt des Erweichens des Trägers (7) am Ort des Fensters (18) vor und/oder während eines Schrittes des Eindrückens des Chips (4) in das durch das Fenster (18) gebildete Lager aufweist, dergestalt, dass die Seite des Chips (4), die die Abschnitte (3, 3') trägt, im Wesentlichen mit der Oberfläche des Trägers (7) bündig ist, wobei der Raum, der den in das Fenster (18) eingesetzten Chip (4) umgibt, zumindest teilweise durch das Fliessen (17) des Materials der unteren Schicht (7") des Trägers (7) ausgefüllt wird.

32. Verfahren nach Anspruch 31, **dadurch gekennzeichnet, dass** ein Klebstoff (16) vor dem Schritt des Eindrückens des Chips (4) in das durch das Fenster (18) gebildete Lager eingebracht wird, dergestalt, dass der Klebstoff (16) die Auffüllung des Raumes, der den in das Lager eingesetzten Chip (4) umgibt, vervollständigt.

33. Verfahren nach Anspruch 1, **dadurch gekennzeichnet, dass** es vorausgehende Schritte des Aufbaus eines Trägers (7), der durch das Übereinanderlegen von zumindest zwei Schichten (7', 7") gebildet wird, sowie der Bildung eines Fensters (18) in der unteren Schicht (7") umfasst, wobei die obere Schicht (7') das Fenster (18) abschliesst, die elektronische Baugruppe mit der Verlegevorrichtung (6) gegenüber dem Fenster (18) der unteren Schicht (7") in die obere Schicht (7') eingedrückt wird, der durch die Verlegevorrichtung (6) ausgeübte Druck das erweichte Material der oberen Schicht (7') in das Fenster (18) fliessen lässt und die Abschnitte (3, 3') sowie der Chip (4) der elektronischen Baugruppe schlussendlich mit der Oberfläche der oberen Schicht (7') bündig sind.

34. Verlegevorrichtung (6), dafür bestimmt, auf einen Träger (7) eine elektronische Baugruppe mit einem Chip (4) aufzusetzen, der mit zumindest einem elektrischen Anschluss (5, 5') versehen ist, der mit einem Leiterbahnabschnitt (3, 3') verbunden ist, wobei die Vorrichtung mit Mitteln für eine Positionierung und ein Einpressen der Baugruppe in den Träger (7) ausgerüstet und **dadurch gekennzeichnet ist, dass** sie einen Kopf aufweist, der mit Mitteln versehen ist, um zumindest einen Leiterbahnabschnitt (3, 3') zu halten, sowie weiter mit Mitteln, um einen Chip (4) zu halten, der so ergriffen wird, dass jeder Bahnabschnitt (3, 3') zumindest einem Anschluss (5, 5') des Chips (4) gegenüber liegt oder daran angedrückt wird.

35. Vorrichtung nach Anspruch 34, **dadurch gekennzeichnet, dass** die Mittel zum Halten des zumindest einen Bahnabschnitts (3, 3') aus Luftansauglöchern (10, 10') bestehen, die ein Vakuum auf einer der Seiten des zumindest einen Abschnitts (3, 3') erzeugen und so den Abschnitt (3, 3') an den Kopf angedrückt halten.

36. Vorrichtung nach Anspruch 35, **dadurch gekennzeichnet, dass** die Mittel zum Halten des Chips (4) zumindest ein Luftansaugloch (11) umfassen, das in einem mittleren Bereich des Kopfes der Vorrichtung in der Nähe zumindest eines Endes des von den entsprechenden Löchern (10, 10') gehaltenen Bahnabschnitts (3, 3') liegt.

37. Vorrichtung nach Anspruch 34, **dadurch gekennzeichnet, dass** die Mittel zum Halten des Chips (4) Haftelemente umfassen.

38. Vorrichtung nach Anspruch 34, **dadurch gekennzeichnet, dass** der Kopf Mittel zum Anschweissen des zumindest einen Leiterbahnabschnitts (3, 3') an zumindest einen Anschluss (5, 5') des Chips (4) aufweist.
